# EUROPEAN PATENT APPLICATION

(11) **EP 4 517 918 A1**
(43) Date of publication of application: **05.03.2025**
(21) Application number: 23796388.9
(22) Date of filing: 25.04.2023
(51) Int. Cl.: H01M 10/42, H01M 10/48

(54) **BATTERY MANAGEMENT SYSTEM**

(30) Priority: 27.04.2022 US 202263335435 P
(71) Applicant: Nuvoton Technology Corporation Japan, Nagaokakyo City, Kyoto 617-8520 (JP)
(72) Inventor: YOSHIKAWA, Susumu, Nagaokakyo City, Kyoto 617-8520 (JP); KOBAYASHI, Hitoshi, Nagaokakyo City, Kyoto 617-8520 (JP); FUJII, Keiichi, Nagaokakyo City, Kyoto 617-8520 (JP); KAWABE, Akira, Nagaokakyo City, Kyoto 617-8520 (JP)
(74) Representative: Novagraaf International SA
(86) International application number: PCT/JP2023/016324
(87) International publication number: WO 2023/210648

(57) **Abstract**

A BMS (1) includes: a BMU (202) that manages a battery assembly; and a plurality of CMUs (101, 103, 302, and 303) that monitor the battery assembly. Among the plurality of CMUs (101, 103, 302, and 303), a first CMU (101) includes a first wireless communication circuit (111) and a first communication antenna (ANT1) for communicating with the BMU (202), and a second CMU (302) includes a second wireless communication circuit (315) and a second communication antenna (ANTS) for communicating with the BMU (202). The modulation scheme for wireless communication by the first wireless communication circuit (111) is different from the modulation scheme for wireless communication by the second wireless communication circuit (315).

## Description

### [Technical Field]

The present disclosure relates to a battery management system for managing a battery assembly.

### [Background Art]

Patent Literature (PTL) 1 discloses a technique in which, within a battery management system, when a functional unit experiences a failure in wireless communication with a battery management unit, the functional unit changes the frequency at which it communicates with the battery management unit and re-establishes the wireless communication connection with the battery management unit.

### [Citation List]

### [Patent Literature]

[PTL 1] U.S. Patent Application Publication No. 2020/0083722

### [Summary of Invention]

### [Technical Problem]

However, with the technique disclosed in PTL 1, when the robustness of communication is low, there is a risk that the wireless communication connection cannot be re-established.

In view of the above, the present disclosure provides a battery management system that can increase the robustness of communication within the battery management system.

### [Solution to Problem]

A battery management system according to the present disclosure is for managing a battery assembly, and includes: a management circuit that manages the battery assembly; and a plurality of monitoring circuits that monitor the battery assembly. A first monitoring circuit among the plurality of monitoring circuits includes a first wireless communication circuit and a first communication antenna for communicating with the management circuit, a second monitoring circuit among the plurality of monitoring circuits includes a second wireless communication circuit and a second communication antenna for communicating with the management circuit, and a modulation scheme of wireless communication by the first wireless communication circuit is different from a modulation scheme of wireless communication by the second wireless communication circuit.

A battery management system according to the present disclosure is for managing a battery assembly, and includes: a management circuit that manages the battery assembly; and a plurality of monitoring circuits that monitor the battery assembly. A first monitoring circuit among the plurality of monitoring circuits includes a first wireless communication circuit and a first communication antenna for communicating with the management circuit, a second monitoring circuit among the plurality of monitoring circuits includes a second wireless communication circuit and a second communication antenna for communicating with the management circuit, and a wireless communication channel used for wireless communication by the first wireless communication circuit is different from a wireless communication channel used for wireless communication by the second wireless communication circuit.

General or specific aspects of the present disclosure may be realized as a system, a method, an integrated circuit, a computer program, a computer-readable recording medium such as CD-ROM, or any given combination thereof.

### [Advantageous Effects of Invention]

With the battery management system according to one aspect of the present disclosure, the robustness of communication within the battery management system can be increased.

### [Brief Description of Drawings]

[FIG. 1]

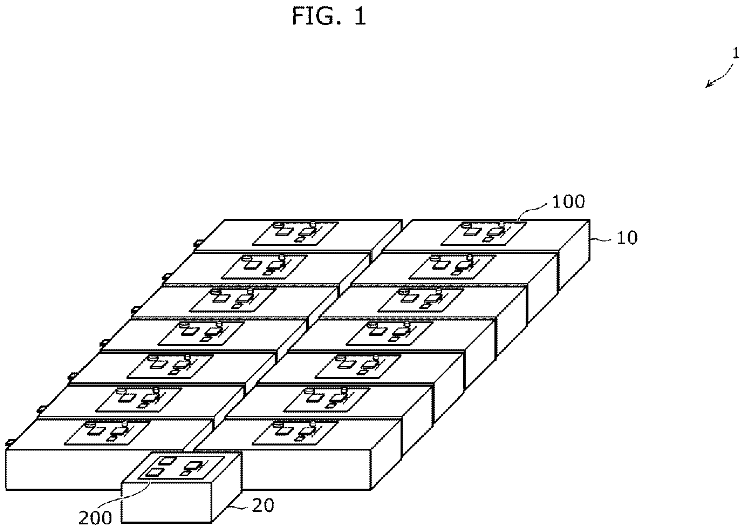

   FIG. 1 is an external view illustrating one example of a battery management system according to an embodiment of the present disclosure.
[FIG. 2]

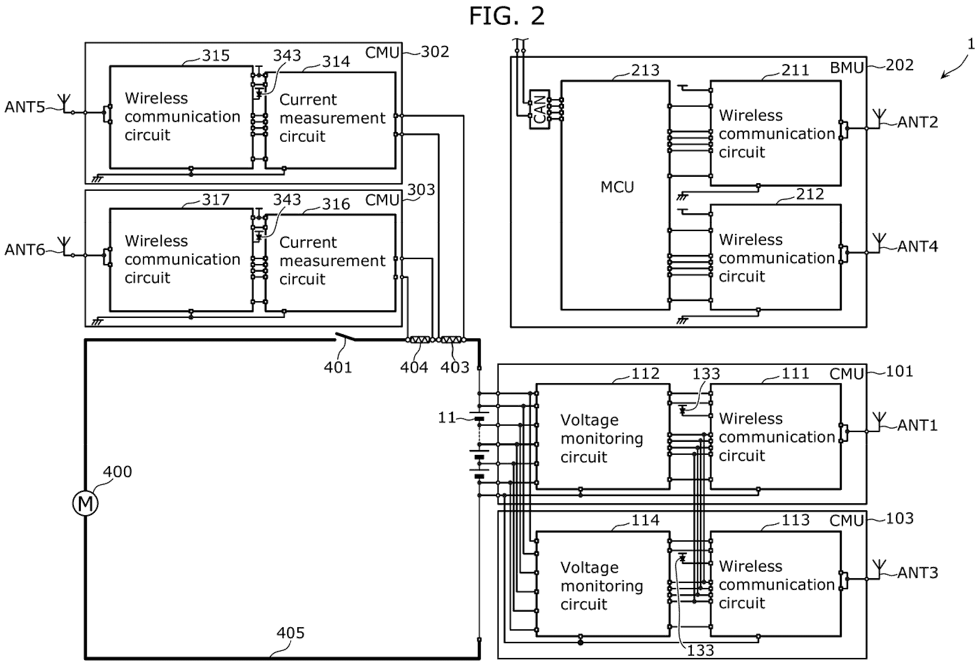

   FIG. 2 is a configuration diagram illustrating one example of a battery management system according to an embodiment of the present disclosure.
[FIG. 3A]

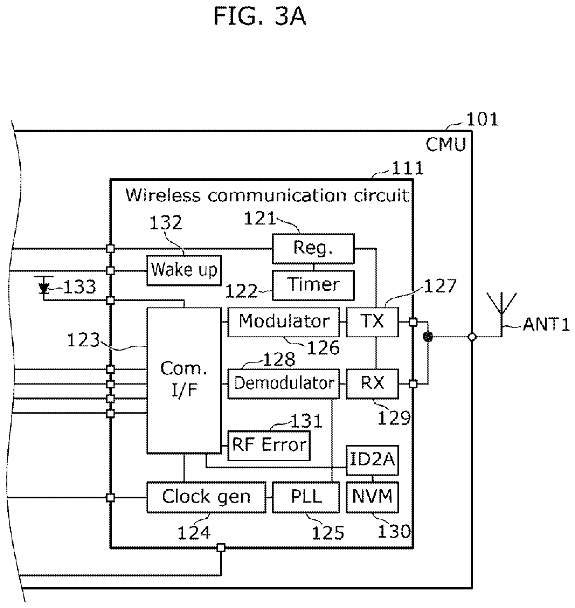

   FIG. 3A is a configuration diagram illustrating one example of a wireless communication circuit included in a cell monitoring circuit.
[FIG. 3B]

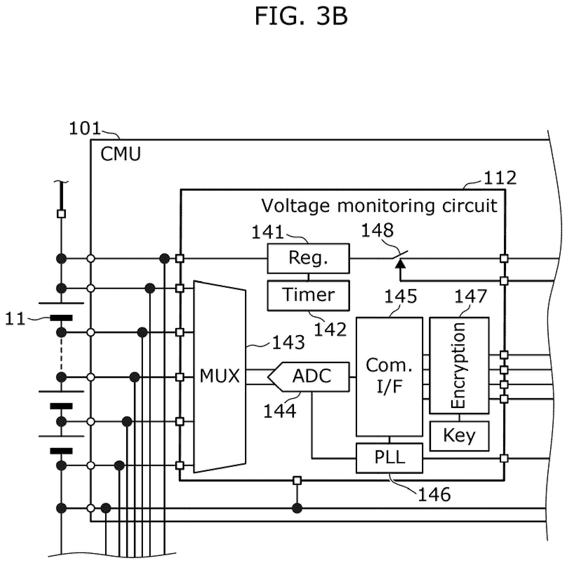

   FIG. 3B is a configuration diagram illustrating one example of a voltage monitoring circuit included in a cell monitoring circuit.
[FIG. 4]

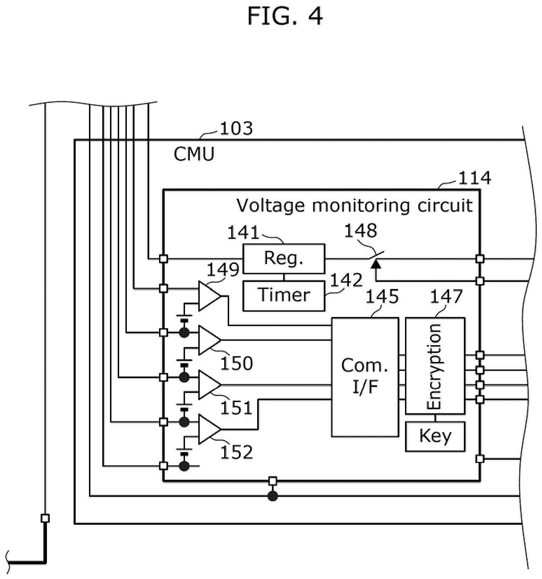

   FIG. 4 is a configuration diagram illustrating another example of a voltage monitoring circuit included in a cell monitoring circuit.
[FIG. 5A]

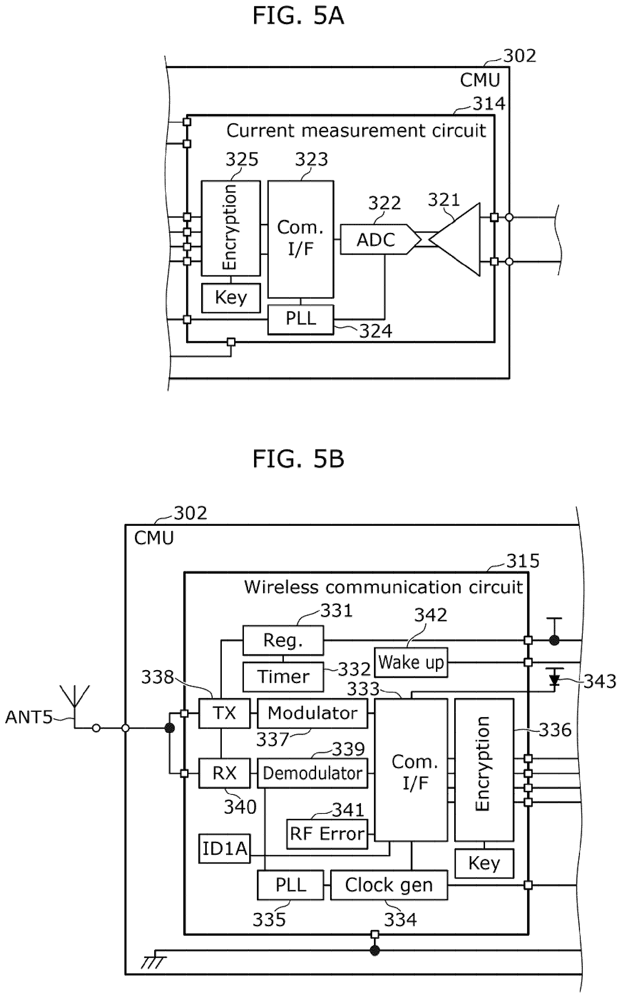

   FIG. 5A is a configuration diagram illustrating one example of a current measurement circuit included in a current monitoring circuit.
[FIG. 5B]
   FIG. 5B is a configuration diagram illustrating one example of a wireless communication circuit included in a current monitoring circuit.
[FIG. 6A]

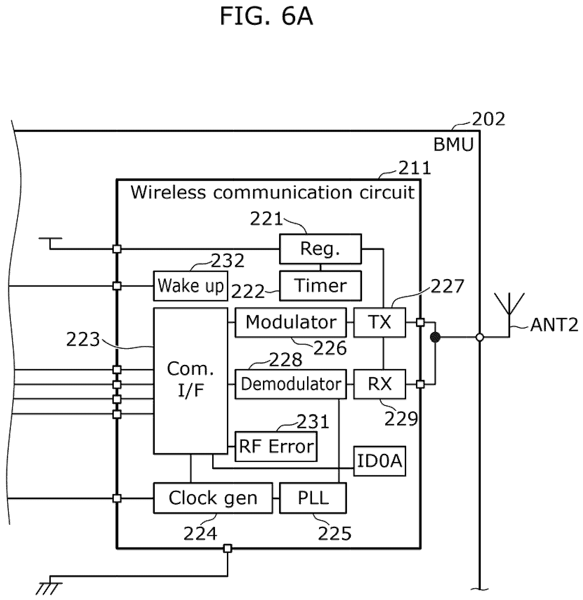

   FIG. 6A is a configuration diagram illustrating one example of a wireless communication circuit included in a management circuit.
[FIG. 6B]

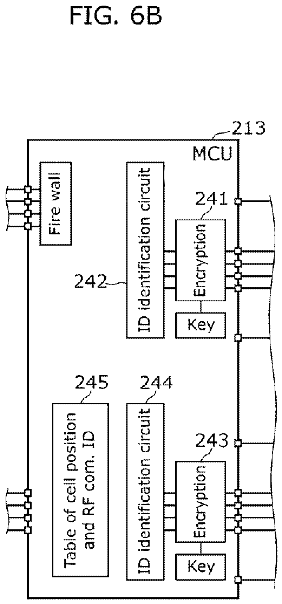

   FIG. 6B is a configuration diagram illustrating one example of an MCU included in a management circuit.
[FIG. 7]

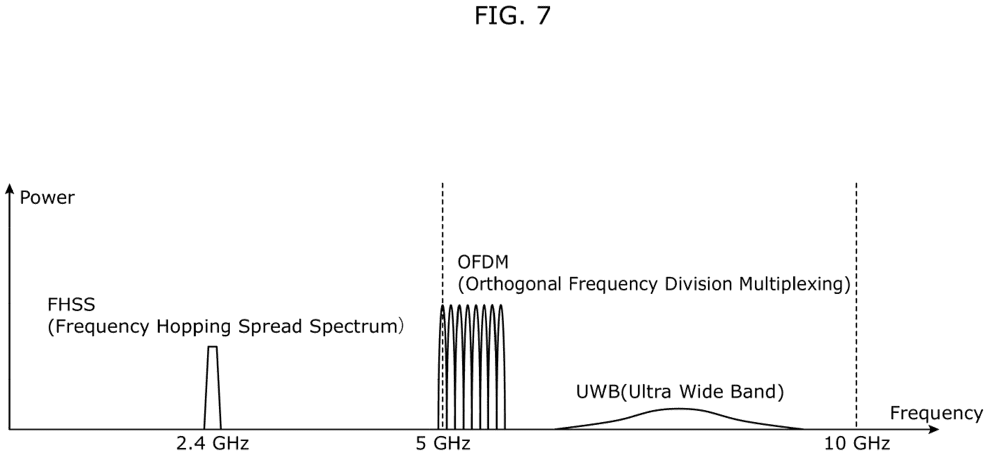

   FIG. 7 illustrates an example of modulation schemes for wireless communication.
[FIG. 8]

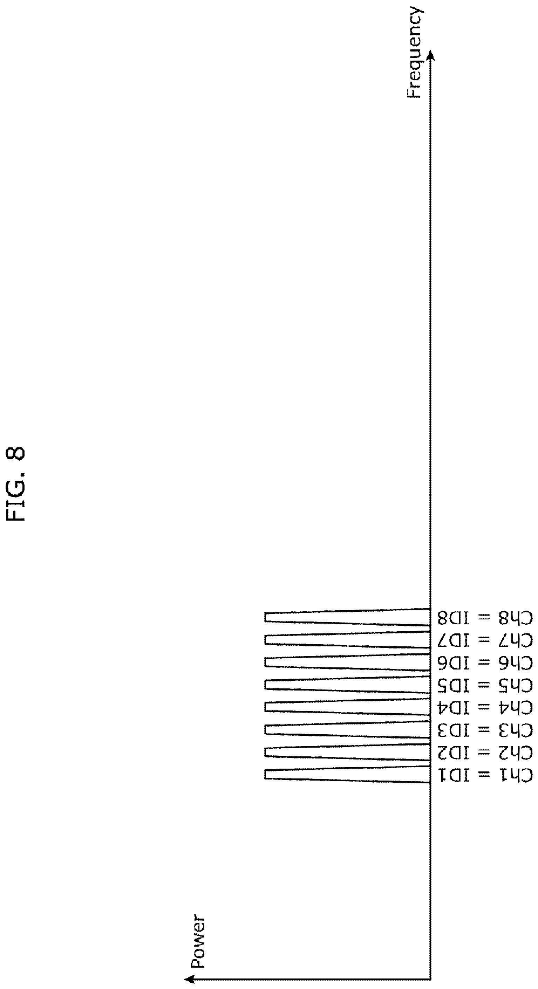

   FIG. 8 illustrates an example of wireless communication channels.
[FIG. 9]

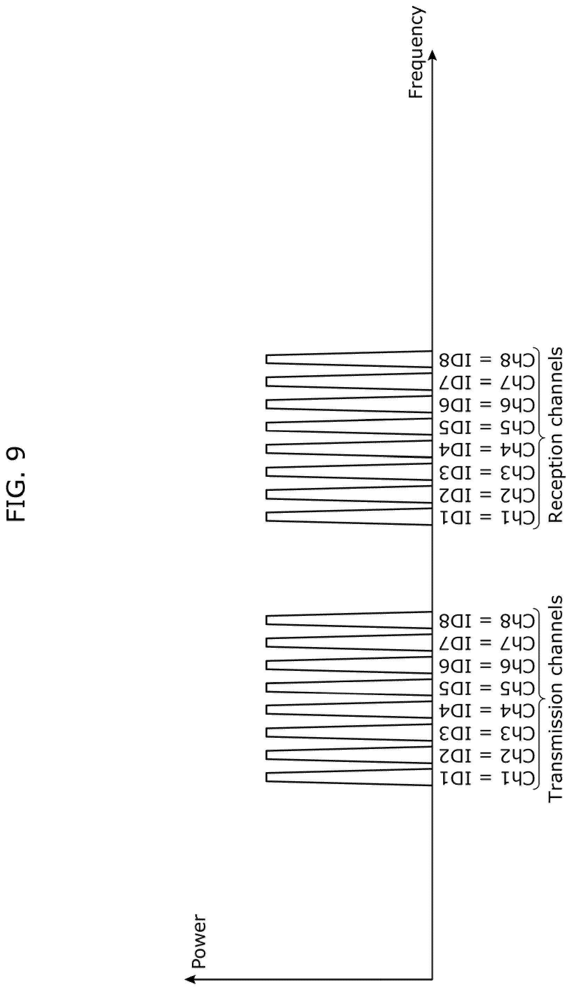

   FIG. 9 illustrates an example of transmission wireless communication channels and reception wireless communication channels.

### [Description of Embodiments]

Hereinafter, one or more embodiments of the present disclosure will be described in detail with reference to the drawings.

Each embodiment described below illustrates a general or specific example. The numerical values, shapes, materials, elements, the arrangement and connection of the elements, etc., shown in the following embodiments are mere examples, and therefore do not limit the scope of the present disclosure.

### [Embodiment]

Hereinafter, a battery management system according to an embodiment of the present disclosure will be described.

FIG. 1 is an external view illustrating one example of battery management system (hereinafter also "BMS") 1 according to an embodiment of the present disclosure.

BMS 1 is a system for managing a battery assembly. For example, BMS 1 manages the state of charge (SOC), state of health (SOH), and state of power (SOP) of the battery assembly. BMS 1 monitors anomalies in the battery assembly. BMS 1 includes management circuit 200 that manages the battery assembly, and a plurality of monitoring circuits 100 that monitor the battery assembly. For example, the battery assembly includes a plurality of battery packs 10 connected in series or parallel. Battery pack 10 includes one or more battery cells. When battery pack 10 includes a plurality of battery cells, the plurality of battery cells are connected in series.

For example, monitoring circuit 100 is disposed on each of the plurality of battery packs 10. For example, the plurality of monitoring circuits 100 include a monitoring circuit (cell monitoring unit (CMU)) that monitors one or more battery cells included in the battery assembly or a current monitoring circuit (current monitoring unit (CMU)) that measures current flowing in the battery assembly. Specific examples of monitoring circuit 100, namely cell monitoring units (CMUs) 101 and 103 and current monitoring units (CMUs) 302 and 303, will be described later.

For example, management circuit 200 is connected to a battery assembly via junction box 20. Specific examples of management circuit 200, namely battery management unit (BMU) 202, will be described later.

Next, a specific example of BMS 1 according to an embodiment of the present disclosure will be given with reference to FIG. 2 through FIG. 6B.

FIG. 2 is a configuration diagram illustrating one example of BMS 1 according to an embodiment of the present disclosure.

FIG. 3A is a configuration diagram illustrating one example of wireless communication circuit 111 included in a cell monitoring circuit (for example, CMU 101). Note that FIG. 3A also illustrates elements peripheral to wireless communication circuit 111 in the configuration diagram of FIG. 2.

FIG. 3B is a configuration diagram illustrating one example of voltage monitoring circuit 112 included in a cell monitoring circuit (for example, CMU 101). Note that FIG. 3B also illustrates elements peripheral to voltage monitoring circuit 112 in the configuration diagram of FIG. 2.

FIG. 4 is a configuration diagram illustrating another example of voltage monitoring circuit 114 included in a cell monitoring circuit (for example, CMU 103). Note that FIG. 4 also illustrates elements peripheral to voltage monitoring circuit 114 in the configuration diagram of FIG. 2.

FIG. 5A is a configuration diagram illustrating one example of current measurement circuit 314 included in a current monitoring circuit (for example, CMU 302). Note that FIG. 5A also illustrates elements peripheral to current measurement circuit 314 in the configuration diagram of FIG. 2.

FIG. 5B is a configuration diagram illustrating one example of wireless communication circuit 315 included in a current monitoring circuit (for example, CMU 302). Note that FIG. 5B also illustrates elements peripheral to wireless communication circuit 315 in the configuration diagram of FIG. 2.

FIG. 6A is a configuration diagram illustrating one example of wireless communication circuit 211 included in the management circuit (BMU 202). Note that FIG. 6A also illustrates elements peripheral to wireless communication circuit 211 in the configuration diagram of FIG. 2.

FIG. 6B is a configuration diagram illustrating one example of MCU 213 included in the management circuit (BMU 202). Note that FIG. 6B also illustrates elements peripheral to MCU 213 in the configuration diagram of FIG. 2.

In the specific example of FIG. 2, focusing on one battery pack 10 among the plurality of battery packs 10, FIG. 2 illustrates a plurality of battery cells 11 included in one battery pack 10 in the battery assembly as the one or more battery cells included in the battery assembly. CMUs 101 and 103 as well as CMUs 302 and 303 are illustrated as monitoring circuit 100, and BMU 202 is illustrated as management circuit 200. Motor 400 is illustrated as a load to which power is supplied from the battery assembly. Power line 405 (bus bar) connecting the battery assembly and motor 400, and relay 401 as well as shunt resistors 403 and 404 inserted in power line 405 are also illustrated.

Relay 401 is a switch for interrupting current flowing in power line 405. For example, relay 401 is turned off to interrupt current flowing in power line 405 when the current monitored by CMU 302 or 303 is determined to be anomalous. Also, for example, relay 401 is turned off to interrupt current flowing in power line 405 when the voltage monitored by CMU 101 or 103 is determined to be anomalous.

Shunt resistors 403 and 404 are resistors for measuring current flowing in power line 405.

CMUs 101 and 103 are one example of a cell monitoring circuit that monitors one or more battery cells included in the battery assembly. For example, CMUs 101 and 103 monitor the voltage of each of the plurality of battery cells 11. Here, an example is given where CMU 101 and CMU 103 each monitor the same battery cells 11 (specifically, battery cells 11 included in same battery pack 10), but CMU 101 and CMU 103 may each monitor different battery cells 11 (specifically, battery cells 11 included in different battery packs 10).

CMUs 101 and 103 are connected to each other via wired communication, but they need not be connected to each other via wired communication.

As illustrated in FIG. 2, CMU 101 includes wireless communication circuit 111 and communication antenna ANT1 for communicating with BMU 202. CMU 101 includes voltage monitoring circuit 112. For example, wireless communication circuit 111 and voltage monitoring circuit 112 are each implemented by different integrated circuits (ICs). Note that wireless communication circuit 111 and voltage monitoring circuit 112 may be implemented by a single IC.

As illustrated in FIG. 3A, wireless communication circuit 111 includes voltage conversion circuit (Reg.) 121, timer circuit (Timer) 122, communications interface (Com. I/F) 123, clock generation circuit (Clock gen) 124, phase-locked loop (PLL) 125, modulation circuit (Modulator) 126, transmission circuit (Tx) 127, demodulation circuit (Demodulator) 128, reception circuit (Rx) 129, non-volatile memory (NVM) 130, communication error determination circuit (RF Error) 131, and wake-up circuit (Wake up) 132.

Voltage conversion circuit 121 is a circuit that converts the voltage input from voltage monitoring circuit 112 to a voltage for operating wireless communication circuit 111 and outputs the converted voltage.

Timer circuit 122 is a circuit that counts time. For example, timer circuit 122 is used to operate wireless communication circuit 111 intermittently.

Communications interface 123 is an interface for performing communication between wireless communication circuit 111 and voltage monitoring circuit 112. Note that when wireless communication circuit 111 and voltage monitoring circuit 112 are implemented by a single IC, communications interface 123 may be omitted.

Clock generation circuit 124 is a circuit for generating a clock in CMU 101.

Phase-locked loop 125 is a circuit that adjusts the phase of a local signal to match the phase of a received signal.

Modulation circuit 126 is a circuit that modulates signals to be transmitted to BMU 202.

Transmission circuit 127 is a circuit for transmitting signals to BMU 202. Transmission circuit 127 transmits signals to BMU 202 via communication antenna ANT1.

Demodulation circuit 128 is a circuit that demodulates signals received from BMU 202.

Reception circuit 129 is a circuit for receiving signals from BMU 202. Reception circuit 129 receives signals from BMU 202 via communication antenna ANT1.

Non-volatile memory 130 stores identification information of wireless communication circuit 111. For example, non-volatile memory 130 stores the identification information "ID2A". Note that FIG. 3A illustrates non-volatile memory 130, but the identification information may be stored in any memory included in wireless communication circuit 111. The illustration of the memory in which identification information is stored is omitted for the wireless communication circuit, which will be described later.

Communication error determination circuit 131 is a circuit that determines whether an anomaly has occurred in the communication between CMU 101 and BMU 202.

Wake-up circuit 132 is a circuit for activating wireless communication circuit 111.

As illustrated in FIG. 2, CMU 101 may include LED 133, for example. For example, LED 133 emits light when wireless communication circuit 111 satisfies a specific condition.

As illustrated in FIG. 3B, voltage monitoring circuit 112 includes voltage conversion circuit (Reg.) 141, timer circuit (Timer) 142, multiplexer (MUX) 143, AD converter (ADC) 144, communications interface (Com. I/F) 145, phase-locked loop (PLL) 146, encryption circuit (Encryption) 147, and switch 148.

Voltage conversion circuit 141 is a circuit that converts the voltage input from the battery assembly to a voltage for operating voltage monitoring circuit 112 and outputs the converted voltage.

Timer circuit 142 is a circuit that counts time. For example, timer circuit 142 is a circuit for operating wireless communication circuit 111 intermittently. Although CMU 101 includes timer circuits 122 and 142 in wireless communication circuit 111 and voltage monitoring circuit 112, respectively, CMU 101 need not include both timer circuits 122 and 142. Stated differently, wireless communication circuit 111 need not include timer circuit 122, or voltage monitoring circuit 112 need not include timer circuit 142.

Multiplexer 143 selects one battery cell 11 from among the plurality of battery cells 11 and outputs the terminal voltage of the selected battery cell 11. Stated differently, multiplexer 143 can output the voltage of each of the plurality of battery cells 11.

AD converter 144 converts the voltage value (analog value) of battery cell 11 selected by multiplexer 143 into a digital value.

Communications interface 145 is an interface for performing communication between wireless communication circuit 111 and voltage monitoring circuit 112. Note that when wireless communication circuit 111 and voltage monitoring circuit 112 are implemented by a single IC, communications interface 145 may be omitted.

Phase-locked loop 146 is a circuit that adjusts the phase of a local signal to match the phase of a received signal.

Encryption circuit 147 is a circuit that encrypts and decrypts signals. For example, encryption circuit 147 encrypts signals to be transmitted to wireless communication circuit 111 and ultimately to BMU 202, using an encryption key (Key).

Switch 148 is a switch that toggles on and off the power supply to wireless communication circuit 111, and is, for example, a transistor or the like. Switch 148 is controlled by a control signal from wake-up circuit 132. Wake-up circuit 132 can control the activation of wireless communication circuit 111 by controlling switch 148 to control the power supply to wireless communication circuit 111.

CMU 101 detects the voltage value of each of the plurality of battery cells 11 using voltage monitoring circuit 112, and transmits the detected voltage values to BMU 202 using wireless communication circuit 111.

As illustrated in FIG. 2, CMU 103 includes wireless communication circuit 113 and communication antenna ANT3 for communicating with BMU 202. CMU 103 includes voltage monitoring circuit 114. For example, wireless communication circuit 113 and voltage monitoring circuit 114 are each implemented by different ICs. Note that wireless communication circuit 113 and voltage monitoring circuit 114 may be implemented by a single IC.

The explanation of the functions of wireless communication circuit 113 is the same as the explanation of wireless communication circuit 111, with "voltage monitoring circuit 112" replaced by "voltage monitoring circuit 114", "communication antenna ANT1" replaced by "communication antenna ANT3", and "CMU 101" replaced by "CMU 103".

As illustrated in FIG. 4, voltage monitoring circuit 114 includes voltage conversion circuit (Reg.) 141, timer circuit (Timer) 142, communications interface (Com. I/F) 145, encryption circuit (Encryption) 147, switch 148, and comparators 149 to 152.

The explanation of the functions of voltage conversion circuit 141, timer circuit 142, communications interface 145, encryption circuit 147, and switch 148 included in voltage monitoring circuit 114 is the same as the explanation of those included in voltage monitoring circuit 112 described above, with "wireless communication circuit 111" replaced by "wireless communication circuit 113", "voltage monitoring circuit 112" replaced by "voltage monitoring circuit 114", and "CMU 101" replaced by "CMU 103".

Comparators 149 to 152 are provided one-to-one with respect to the plurality of battery cells 11. Here, four comparators 149 to 152 are illustrated as one example, but the number of comparators corresponds to the number of battery cells 11. For example, when four battery cells 11 are connected in series as the plurality of battery cells 11, comparator 149 compares the voltage of the first battery cell 11 with a predetermined voltage, comparator 150 compares the voltage of the second battery cell 11 with a predetermined voltage, comparator 151 compares the voltage of the third battery cell 11 with a predetermined voltage, and comparator 152 compares the voltage of the fourth battery cell 11 with a predetermined voltage. In this way, by providing comparators one-to-one with respect to the plurality of battery cells 11, voltage monitoring circuit 114 can determine whether each of the plurality of battery cells 11 is greater than or equal to a predetermined voltage (for example, whether it is overcharged) or whether each of the plurality of battery cells 11 is less than or equal to a predetermined voltage (for example, whether the voltage is too low). Stated differently, voltage monitoring circuit 114 can determine whether the voltage of each of the plurality of battery cells 11 is anomalous or not.

CMU 103 determines whether the voltage of each of the plurality of battery cells 11 is anomalous or not using voltage monitoring circuit 114, and transmits the determination result to BMU 202 using wireless communication circuit 113.

CMU 103 may include voltage monitoring circuit 112 instead of voltage monitoring circuit 114. Stated differently, CMU 103 may detect the voltage value of each of the plurality of battery cells 11, and transmit the detected voltage values to BMU 202. CMU 101 may include voltage monitoring circuit 114 instead of voltage monitoring circuit 112. Stated differently, CMU 101 may determine whether the voltage of each of the plurality of battery cells 11 is anomalous or not, and transmit the determination result to BMU 202.

As illustrated in FIG. 2, CMU 302 includes current measurement circuit 314 that measures current flowing in the battery assembly. CMU 302 includes wireless communication circuit 315 and communication antenna ANT5 for communicating with BMU 202. For example, wireless communication circuit 315 and current measurement circuit 314 are each implemented by different ICs. Note that wireless communication circuit 315 and current measurement circuit 314 may be implemented by a single IC.

As illustrated in FIG. 5A, current measurement circuit 314 includes amplification circuit 321, AD converter (ADC) 322, communications interface (Com. I/F) 323, phase-locked loop (PLL) 324, and encryption circuit (Encryption) 325.

Amplification circuit 321 amplifies the voltage generated across shunt resistor 403. Amplification circuit 321 is provided because the resistance value of shunt resistor 403 is extremely small, and the voltage generated across shunt resistor 403 is also small.

AD converter 322 converts the voltage value (analog value) generated across shunt resistor 403 into a digital value.

Communications interface 323 is an interface for performing communication between wireless communication circuit 315 and current measurement circuit 314. Note that when wireless communication circuit 315 and current measurement circuit 314 are implemented by a single IC, communications interface 323 may be omitted.

Phase-locked loop 324 is a circuit that adjusts the phase of a local signal to match the phase of a received signal.

Encryption circuit 325 is a circuit that encrypts and decrypts signals. For example, encryption circuit 325 encrypts signals to be transmitted to wireless communication circuit 315 and ultimately to BMU 202, using an encryption key (Key).

As illustrated in FIG. 5B, wireless communication circuit 315 includes voltage conversion circuit (Reg.) 331, timer circuit (Timer) 332, communications interface (Com. I/F) 333, clock generation circuit (Clock gen) 334, phase-locked loop (PLL) 335, encryption circuit (Encryption) 336, modulation circuit (Modulator) 337, transmission circuit (Tx) 338, demodulation circuit (Demodulator) 339, reception circuit (Rx) 340, communication error determination circuit (RF Error) 341, and wake-up circuit (Wake up) 342. FIG. 5B illustrates "ID1A" as the identification information of wireless communication circuit 315.

Voltage conversion circuit 331 is a circuit that converts the voltage input from any power source to a voltage for operating wireless communication circuit 315 and outputs the converted voltage.

Timer circuit 332 is a circuit that counts time.

Communications interface 333 is an interface for performing communication between wireless communication circuit 315 and current measurement circuit 314. Note that when wireless communication circuit 315 and current measurement circuit 314 are implemented by a single IC, communications interface 333 may be omitted.

Clock generation circuit 334 is a circuit for generating a clock in CMU 302.

Phase-locked loop 335 is a circuit that adjusts the phase of a local signal to match the phase of a received signal.

Encryption circuit 336 is a circuit that encrypts and decrypts signals. For example, encryption circuit 336 encrypts signals to be transmitted to BMU 202, using an encryption key (Key). Although CMU 302 includes encryption circuits 325 and 336 in current measurement circuit 314 and wireless communication circuit 315, respectively, CMU 302 need not include both encryption circuits 325 and 336. Stated differently, wireless communication circuit 315 need not include encryption circuit 336, or current measurement circuit 314 need not include encryption circuit 325.

Modulation circuit 337 is a circuit that modulates signals to be transmitted to BMU 202.

Transmission circuit 338 is a circuit for transmitting signals to BMU 202. Transmission circuit 338 transmits signals to BMU 202 via communication antenna ANT5.

Demodulation circuit 339 is a circuit that demodulates signals received from BMU 202.

Reception circuit 340 is a circuit for receiving signals from BMU 202. Reception circuit 340 receives signals from BMU 202 via communication antenna ANT5.

Communication error determination circuit 341 is a circuit that determines whether an anomaly has occurred in the communication between CMU 302 and BMU 202.

Wake-up circuit 342 is a circuit for activating current measurement circuit 314.

As illustrated in FIG. 2, CMU 302 may include LED 343, for example. For example, LED 343 emits light when wireless communication circuit 315 satisfies a specific condition.

As illustrated in FIG. 2, CMU 303 includes current measurement circuit 316 that measures current flowing in the battery assembly. CMU 303 includes wireless communication circuit 317 and communication antenna ANT6 for communicating with BMU 202. For example, wireless communication circuit 317 and current measurement circuit 316 are each implemented by different ICs. Note that wireless communication circuit 317 and current measurement circuit 316 may be implemented by a single IC.

The explanation of the functions of current measurement circuit 316 is the same as the explanation of current measurement circuit 314, with "shunt resistor 403" replaced by "shunt resistor 404", "current measurement circuit 314" replaced by "current measurement circuit 316", and "wireless communication circuit 315" replaced by "wireless communication circuit 317".

The explanation of the functions of wireless communication circuit 317 is the same as the explanation of wireless communication circuit 315, with "current measurement circuit 314" replaced by "current measurement circuit 316", "wireless communication circuit 315" replaced by "wireless communication circuit 317", "CMU 302" replaced by "CMU 303", and "communication antenna ANT5" replaced by "communication antenna ANT6". Note that the identification information of wireless communication circuit 317 is ""ID1B".

As illustrated in FIG. 2, BMU 202 includes wireless communication circuit 211 and communication antenna ANT2, as well as wireless communication circuit 212 and communication antenna ANT4, for communicating with CMUs 101 and 103 as well as CMUs 302 and 303. BMU 202 also includes MCU 213 for managing the battery assembly. Note that wireless communication circuits 211 and 212 as well as MCU 213 may be implemented by a single IC (for example, a single MCU).

As illustrated in FIG. 6A, wireless communication circuit 211 includes voltage conversion circuit (Reg.) 221, timer circuit (Timer) 222, communications interface (Com. I/F) 223, clock generation circuit (Clock gen) 224, phase-locked loop (PLL) 225, modulation circuit (Modulator) 226, transmission circuit (Tx) 227, demodulation circuit (Demodulator) 228, reception circuit (Rx) 229, communication error determination circuit (RF Error) 231, and wake-up circuit (Wake up) 232. FIG. 6A illustrates ""ID0A" as the identification information of wireless communication circuit 211.

Voltage conversion circuit 221 is a circuit that converts the voltage input from any power source to a voltage for operating wireless communication circuit 211 and outputs the converted voltage.

Timer circuit 222 is a circuit that counts time.

Communications interface 223 is an interface for performing communication between wireless communication circuit 211 and MCU 213. Note that when wireless communication circuit 211 and MCU 213 are implemented by a single IC, communications interface 223 may be omitted.

Clock generation circuit 224 is a circuit for generating a clock in BMU 202.

Phase-locked loop 225 is a circuit that adjusts the phase of a local signal to match the phase of a received signal.

Modulation circuit 226 is a circuit that modulates signals to be transmitted to CMU 101 or 103, or CMU 302 or 303.

Transmission circuit 227 is a circuit for transmitting signals to CMU 101 or 103, or CMU 302 or 303. Transmission circuit 227 transmits signals to CMU 101 or 103, or CMU 302 or 303 via communication antenna ANT2.

Demodulation circuit 228 is a circuit that demodulates signals received from CMU 101 or 103, or CMU 302 or 303.

Reception circuit 229 is a circuit for receiving signals from CMU 101 or 103, or CMU 302 or 303. Reception circuit 229 receives signals from CMU 101 or 103, or CMU 302 or 303 via communication antenna ANT2.

Communication error determination circuit 231 is a circuit that determines whether an anomaly has occurred in the communication between (i) CMU 101 or 103, or CMU 302 or 303 and (ii) BMU 202.

Wake-up circuit 232 is a circuit for activating MCU 213.

The explanation of the functions of wireless communication circuit 212 is the same as the explanation of wireless communication circuit 211, with "communication antenna ANT2" replaced by "communication antenna ANT4". Note that the identification information of wireless communication circuit 212 is "ID0B".

As illustrated in FIG. 6B, MCU 213 includes encryption circuit (Encryption) 241, identification circuit (ID identification circuit) 242, encryption circuit (Encryption) 243, and identification circuit (ID identification circuit) 244. MCU 213 is connected to a controller area network (CAN), and a firewall is provided between MCU 213 and the CAN. MCU 213 also stores table (table of cell position and RF com. ID) 245 showing the correspondence between the positions of each of the plurality of battery cells 11 in battery pack 10 and identification information such as the wireless communication circuit of the CMU of each battery pack 10.

Encryption circuits 241 and 243 are circuits that encrypt and decrypt signals. For example, encryption circuits 241 and 243 decrypt signals transmitted from CMU 101 or 103 or CMU 302 or 303, using an encryption key (Key).

Identification circuits 242 and 244 use table 245 to identify which position of battery cell 11 in which battery pack 10 the voltage value of battery cell 11 included in the signal transmitted from CMU 101 corresponds to. Identification circuits 242 and 244 use table 245 to identify which position of battery cell 11 in which battery pack 10 the voltage determination result of battery cell 11 included in the signal transmitted from CMU 103 corresponds to.

With the above circuit configuration, BMS 1 operates as follows.

When BMU 202 obtains the states (for example, voltage values) of the plurality of battery cells 11 monitored by the CMU assigned with the identification information "ID2A", it broadcasts a request signal to cause the CMU assigned with the identification information "ID2A"" to transmit the monitoring results to BMU 202.

CMU 101 receives the request signal, and because the identification information included in the request signal matches its own identification information "ID2A", it determines that the request signal is addressed to itself, and performs processing to transmit the monitoring results of the plurality of battery cells 11 that it monitors to BMU 202. More specifically, CMU 101 obtains the voltage value of each of the plurality of battery cells 11 using multiplexer 143, and transmits to BMU 202 each voltage value, information indicating which position of battery cell 11 among the plurality of battery cells 11 each voltage value corresponds to, and the identification information of CMU 101. For example, depending on which battery cell 11 multiplexer 143 selected when obtaining the voltage value, it is possible to identify which position of battery cell 11 among the plurality of battery cells 11 the voltage value corresponds to.

BMU 202 receives, as a response to the request signal, information indicating the voltage values of the plurality of battery cells 11 monitored by CMU 101 and the identification information of CMU 101 from CMU 101. BMU 202 can identify which position of battery cell 11 in which battery pack 10 each of the voltage values of the plurality of battery cells 11 corresponds to by matching these pieces of information with table 245.

When BMU 202 obtains the states (for example, determination results of voltage anomalies) of the plurality of battery cells 11 monitored by the CMU assigned with the identification information "ID2B", it broadcasts a request signal to cause the CMU assigned with the identification information "ID2B" to transmit the monitoring results to BMU 202.

CMU 103 receives the request signal, and because the identification information included in the request signal matches its own identification information "ID2B", it determines that the request signal is addressed to itself, and performs processing to transmit the monitoring results of the plurality of battery cells 11 that it monitors to BMU 202. More specifically, CMU 103 determines whether the voltage of each of the plurality of battery cells 11 is anomalous or not using comparators 149 to 152, and transmits to BMU 202 the determination result of whether the voltage of each of the plurality of battery cells 11 is anomalous, information indicating which position of battery cell 11 among the plurality of battery cells 11 each determination result corresponds to, and the identification information of CMU 103. For example, depending on which comparator obtained the voltage for the determination result, it is possible to identify which position of battery cell 11 among the plurality of battery cells 11 the determination result of voltage anomaly corresponds to.

BMU 202 receives, as a response to the request signal, information indicating the anomaly determination results of the voltages of the plurality of battery cells 11 monitored by CMU 103 and the identification information of CMU 103 from CMU 103. BMU 202 can identify which position of battery cell 11 in which battery pack 10 each of the anomaly determination results for the voltages of the plurality of battery cells 11 corresponds to by matching these pieces of information with table 245.

When BMU 202 obtains the state (for example, current flowing in the battery assembly) of the battery assembly monitored by the CMU assigned with the identification information "ID1A", it broadcasts a request signal to cause the CMU assigned with the identification information "ID1A" to transmit the monitoring results to BMU 202.

CMU 302 receives the request signal, and because the identification information included in the request signal matches its own identification information "ID1A", it performs processing to transmit the monitoring results of the battery assembly that it monitors to BMU 202. More specifically, CMU 302 measures the current flowing in the battery assembly and transmits it to BMU 202. With this, BMU 202 can obtain the current flowing in the battery assembly.

When BMU 202 obtains the state (for example, current flowing in the battery assembly) of the battery assembly monitored by the CMU assigned with the identification information "ID1B", it broadcasts a request signal to cause the CMU assigned with the identification information "ID1B" to transmit the monitoring results to BMU 202.

CMU 303 receives the request signal, and because the identification information included in request signal matches its own identification information "ID1B", it performs processing to transmit the monitoring results of the battery assembly that it monitors to BMU 202. More specifically, CMU 303 measures the current flowing in the battery assembly and transmits it to BMU 202. With this, BMU 202 can obtain the current flowing in the battery assembly.

Any one of CMUs 101, 103, 302, and 303 is a first monitoring circuit that includes a first wireless communication circuit and a first communication antenna for communicating with BMU 202, and any other one of CMUs 101, 103, 302, and 303 is a second monitoring circuit that includes a second wireless communication circuit and a second communication antenna for communicating with BMU 202. Stated differently, the first monitoring circuit may be any CMU among CMUs 101, 103, 302, and 303 as long as it is different from the CMU that is the second monitoring circuit, and the second monitoring circuit may be any CMU among CMUs 101, 103, 302, and 303 as long as it is different from the CMU that is the first monitoring circuit.

For example, BMS 1 is often mounted on the underside of the vehicle and must perform wireless communication in a very narrow space. In such cases, communication quality may deteriorate due to interference or reflection. In view of this, deterioration of communication quality can be inhibited by, for example, making the modulation scheme of wireless communication by the first wireless communication circuit different from the modulation scheme of wireless communication by the second wireless communication circuit. Deterioration of communication quality can also be inhibited by, for example, making the wireless communication channel used for wireless communication by the first wireless communication circuit different from the wireless communication channel used for wireless communication by the second wireless communication circuit.

When the modulation scheme of wireless communication by the first wireless communication circuit is different from the modulation scheme of wireless communication by the second wireless communication circuit, for example, the modulation scheme of wireless communication by the first wireless communication circuit is one of spread spectrum, orthogonal frequency division multiplexing (OFDM), or ultra wide band (UWB), and the modulation scheme of wireless communication by the second wireless communication circuit is one of spread spectrum, OFDM, or UWB that is different from the modulation scheme of wireless communication by the first wireless communication circuit.

FIG. 7 illustrates an example of modulation schemes for wireless communication.

As illustrated in FIG. 7, spread spectrum (for example, frequency hopping spread spectrum (FHSS)), OFDM, and UWB are each modulation schemes that can easily ensure communication quality even under adverse conditions. By selecting and using two of these modulation schemes, communication redundancy can be increased while realizing more robust reliability.

The spread spectrum scheme can realize communication that is resistant to interference with a simple circuit.

The communication performance of wireless communication may vary depending on the transmission path determined by the frequency (wavelength) and the position of the communication station, but OFDM can select the optimal frequency (i.e., the optimal transmission path) to perform communication.

UWB can perform wide-range communication even in narrow transmission paths within BMS 1 by using wideband wireless.

In communication within BMS 1, transmission is performed in a very narrow free space, so the three modulation schemes mentioned above are suitable as modulation schemes to be selectively used to ensure redundancy.

For example, when CMU 101 is considered as the first monitoring circuit and CMU 302 is considered as the second monitoring circuit, wireless communication circuit 111 is the first wireless communication circuit, communication antenna ANT1 is the first communication antenna, wireless communication circuit 315 is the second wireless communication circuit, and communication antenna ANT5 is the second communication antenna.

In this case, the monitoring results of CMU 101 and the monitoring results of CMU 302 are transmitted to BMU 202 using different modulation schemes. For example, the voltage value of each of the plurality of battery cells 11 and the current value flowing through the battery assembly (the current value flowing through each of the plurality of battery cells 11) are transmitted to BMU 202. With this, BMU 202 measures the internal impedance of each of the plurality of battery cells 11.

For example, when CMU 101 is considered as the first monitoring circuit and CMU 103 is considered as the second monitoring circuit, wireless communication circuit 111 is the first wireless communication circuit, communication antenna ANT1 is the first communication antenna, wireless communication circuit 113 is the second wireless communication circuit, and communication antenna ANT3 is the second communication antenna.

In this case, the monitoring results of CMU 101 and the monitoring results of CMU 103 are transmitted to BMU 202 using different modulation schemes. For example, the voltage values of the plurality of battery cells 11 and the determination result of anomaly in the voltages of the plurality of battery cells 11 are transmitted to BMU 202 using different modulation schemes.

Using different modulation schemes for the wireless communication by the first wireless communication circuit and the wireless communication by the second wireless communication circuit makes it possible to inhibit deterioration of communication quality due to interactions (for example, effects of spurious emissions) between the wireless communication by the first wireless communication circuit and the wireless communication by the second wireless communication circuit. This increases the robustness of communication within BMS 1.

When the wireless communication channel used for wireless communication by the first wireless communication circuit is different from the wireless communication channel used for wireless communication by the second wireless communication circuit, for example, the wireless communication channel used for wireless communication by the first wireless communication circuit is assigned according to the identification information assigned to the first monitoring circuit, and the wireless communication channel used for wireless communication by the second wireless communication circuit is assigned according to the identification information assigned to the second monitoring circuit.

FIG. 8 illustrates an example of wireless communication channels.

As illustrated in FIG. 8, the wireless communication channel "Ch1" is assigned to the monitoring circuit with the identification information "ID1". Similarly, wireless communication channels "Ch2" to "Ch8" are assigned to the monitoring circuits with identification information "ID2" to "ID8", respectively.

For example, when CMU 101 is considered as the first monitoring circuit and CMU 302 is considered as the second monitoring circuit, wireless communication circuit 111 is the first wireless communication circuit, communication antenna ANT1 is the first communication antenna, wireless communication circuit 315 is the second wireless communication circuit, and communication antenna ANT5 is the second communication antenna. CMU 101 is assigned a wireless communication channel according to the identification information "ID2A", and CMU 302 is assigned a wireless communication channel according to the identification information "ID1A", and the wireless communication channels of CMU 101 and CMU 302 are different from each other.

In this case, the monitoring results of CMU 101 and the monitoring results of CMU 302 are transmitted to BMU 202 using different wireless communication channels. For example, the voltage value of each of the plurality of battery cells 11 and the current value flowing through the battery assembly (the current value flowing through each of the plurality of battery cells 11) are transmitted to BMU 202 using different wireless communication channels. With this, BMU 202 measures the internal impedance of each of the plurality of battery cells 11.

For example, when CMU 101 is considered as the first monitoring circuit and CMU 103 is considered as the second monitoring circuit, wireless communication circuit 111 is the first wireless communication circuit, communication antenna ANT1 is the first communication antenna, wireless communication circuit 113 is the second wireless communication circuit, and communication antenna ANT3 is the second communication antenna. CMU 101 is assigned a wireless communication channel according to the identification information "ID2A", and CMU 103 is assigned a wireless communication channel according to the identification information "ID2B", and the wireless communication channels of CMU 101 and CMU 103 are different from each other.

In this case, the monitoring results of CMU 101 and the monitoring results of CMU 103 are transmitted to BMU 202 using different wireless communication channels. For example, the voltage values of the plurality of battery cells 11 and the determination result of anomaly in the voltages the plurality of battery cells 11 are transmitted to BMU 202 using different wireless communication channels.

Using different wireless communication channels for the wireless communication by the first wireless communication circuit and the wireless communication by the second wireless communication circuit makes it possible to inhibit deterioration of communication quality due to interactions (for example, effects of spurious emissions) between the wireless communication by the first wireless communication circuit and the wireless communication by the second wireless communication circuit. This increases the robustness of communication within BMS 1.

In BMS 1, the simultaneity of measuring the voltage of each of the plurality of battery cells 11 included in the battery assembly is important. This is because voltages of the plurality of battery cells 11 measured at the same timing are necessary when detecting an anomaly in the battery assembly. By differentiating the wireless communication channels used for transmitting each voltage measurement result, these measurement results can be transmitted simultaneously, improving the anomaly detection capability of the battery assembly.

The simultaneity of measuring the voltage and current of each of the plurality of battery cells 11 included in the battery assembly is important. This is because the internal impedances (voltages/currents) of battery cells 11 measured at the same timing are necessary when estimating the SOC, SOH, and SOP of the battery assembly. By differentiating the wireless communication channel used for transmitting voltage measurement results and the wireless communication channel used for transmitting current measurement results, these measurement results can be transmitted simultaneously. The measurement accuracy of the internal impedance of battery cells 11 can therefore be improved, and the estimation accuracy of the SOC, SOH, and SOP of the battery assembly can consequently be improved.

Different wireless communication channels can be easily assigned for each CMU by using the identification information assigned to each CMU.

For example, the transmission wireless communication channel used for wireless communication by the first wireless communication circuit may be different from the reception wireless communication channel used for wireless communication by the first wireless communication circuit.

FIG. 9 illustrates an example of transmission wireless communication channels and reception wireless communication channels.

As illustrated in FIG. 9, transmission wireless communication channel "Ch1" and reception wireless communication channel "Ch1" are assigned to the monitoring circuit with identification information "ID1". Similarly, transmission wireless communication channels "Ch2" to "Ch8" and reception wireless communication channels "Ch2" to "Ch8" are assigned to the monitoring circuits with identification information "ID2" to "ID8", respectively.

For example, when CMU 101 is considered as the first monitoring circuit, CMU 101 is assigned a transmission wireless communication channel and a reception wireless communication channel according to the identification information "ID2A". In this case, signal transmission from BMU 202 to CMU 101 and transmission from CMU 101 to BMU 202 may be performed simultaneously.

In this way, by performing full-duplex communication using different wireless communication channels for transmission and reception, the measurement time for internal impedance and the like of battery cells 11 can be shortened.

### Other Embodiments

One or more embodiments have been described above as one or more examples of the techniques according to the present disclosure. However, the techniques according to the present disclosure are not limited to these examples; various changes, substitutions, additions, omissions, etc., may be applied to the embodiments. For example, the following variations are also included in an embodiment of the present disclosure.

In the above embodiment, an example in which two current monitoring circuits are provided was is given, but it is acceptable if only one current monitoring circuit is provided, and it is also acceptable if no current monitoring circuit is provided.

In the above embodiment, each element included in BMS 1 may be configured using dedicated hardware, or may be implemented by executing a software program suitable for the element. Each element may be implemented by a program execution unit such as a CPU or processor reading and executing a software program recorded on a recording medium such as a hard disk or semiconductor memory.

Some or all of the functions of BMS 1 according to the embodiment are typically implemented as LSI circuits, which are integrated circuits. These elements may be integrated into individual chips, or a portion or all of the elements may be integrated into one chip. Circuit integration is not limited to LSI; the elements may be implemented using dedicated circuits or a general-purpose processor. A field programmable gate array (FPGA) which allows programming after manufacturing of the LSI circuits or a reconfigurable processor which allows reconfiguration of the connections and settings of circuit cells inside the LSI circuits may be used.

Furthermore, if a new technology for circuit integration that replaces LSI emerges due to advances in semiconductor technology or other derived technologies, it goes without saying that circuit integration of elements included in BMS 1 may be performed using that technology.

Embodiments arrived at by a person skilled in the art making various modifications to the embodiment, or embodiments realized by arbitrarily combining elements and functions in the embodiments which do not depart from the essence of the present disclosure are also included in the present disclosure.

### Additional Information

The following techniques are disclosed by the description of the above embodiment.

(Technique 1) A battery management system for managing a battery assembly includes: a management circuit that manages the battery assembly; and a plurality of monitoring circuits that monitor the battery assembly. A first monitoring circuit among the plurality of monitoring circuits includes a first wireless communication circuit and a first communication antenna for communicating with the management circuit, a second monitoring circuit among the plurality of monitoring circuits includes a second wireless communication circuit and a second communication antenna for communicating with the management circuit, and a modulation scheme of wireless communication by the first wireless communication circuit is different from a modulation scheme of wireless communication by the second wireless communication circuit.

With this, using different modulation schemes for the wireless communication by the first wireless communication circuit and the wireless communication by the second wireless communication circuit makes it possible to inhibit deterioration of communication quality due to interactions (for example, effects of spurious emissions) between the wireless communication by the first wireless communication circuit and the wireless communication by the second wireless communication circuit. This increases the robustness of communication within the battery management system.

(Technique 2) The battery management system according to Technique 1, wherein the modulation scheme of the wireless communication by the first wireless communication circuit is one of spread spectrum, OFDM, or UWB, and the modulation scheme of the wireless communication by the second wireless communication circuit is one of spread spectrum, OFDM, or UWB that is different from the modulation scheme of the wireless communication by the first wireless communication circuit.

With this, by selecting and using two of these modulation schemes, communication redundancy can be increased while realizing more robust reliability.

(Technique 3) A battery management system for managing a battery assembly includes: a management circuit that manages the battery assembly; and a plurality of monitoring circuits that monitor the battery assembly. A first monitoring circuit among the plurality of monitoring circuits includes a first wireless communication circuit and a first communication antenna for communicating with the management circuit, a second monitoring circuit among the plurality of monitoring circuits includes a second wireless communication circuit and a second communication antenna for communicating with the management circuit, and a wireless communication channel used for wireless communication by the first wireless communication circuit is different from a wireless communication channel used for wireless communication by the second wireless communication circuit.

With this, using different wireless communication channels for the wireless communication by the first wireless communication circuit and the wireless communication by the second wireless communication circuit makes it possible to inhibit deterioration of communication quality due to interactions (for example, effects of spurious emissions) between the wireless communication by the first wireless communication circuit and the wireless communication by the second wireless communication circuit. This increases the robustness of communication within the battery management system.

In the battery management system, the simultaneity of measuring the voltage of each of the plurality of battery cells included in the battery assembly is important. This is because voltages of the plurality of battery cells measured at the same timing are necessary when detecting an anomaly in the battery assembly. By differentiating the wireless communication channels used for transmitting each voltage measurement result, these measurement results can be transmitted simultaneously, improving the anomaly detection capability of the battery assembly.

The simultaneity of measuring the voltage and current of each of the plurality of battery cells included in the battery assembly is important. This is because the internal impedances (voltages/currents) of battery cells measured at the same timing are necessary when estimating the SOC, SOH, and SOP of the battery assembly. By differentiating the wireless communication channel used for transmitting voltage measurement results and the wireless communication channel used for transmitting current measurement results, these measurement results can be transmitted simultaneously. The measurement accuracy of the internal impedance of battery cells can therefore be improved, and the estimation accuracy of the SOC, SOH, and SOP of the battery assembly can consequently be improved.

(Technique 4) The battery management system according to Technique 3, wherein the wireless communication channel used for the wireless communication by the first wireless communication circuit is assigned according to identification information assigned to the first monitoring circuit, and the wireless communication channel used for the wireless communication by the second wireless communication circuit is assigned according to identification information assigned to the second monitoring circuit.

With this, different wireless communication channels can be easily assigned for each monitoring circuit by using the identification information assigned to each monitoring circuits.

(Technique 5) The battery management system according to any one of Techniques 1 to 4, wherein a transmission wireless communication channel used for the wireless communication by the first wireless communication circuit is different from a reception wireless communication channel used for the wireless communication by the first wireless communication circuit.

By performing full-duplex communication using different wireless communication channels for transmission and reception, the measurement time for internal impedance and the like of the battery cells can be shortened.

(Technique 6) The battery management system according to any one of Techniques 1 to 5, wherein the plurality of monitoring circuits include a cell monitoring circuit that monitors one or more battery cells included in the battery assembly or a current monitoring circuit that measures current flowing in the battery assembly.

In this way, the monitoring circuit may be a cell monitoring circuit or a current monitoring circuit.

### [Industrial Applicability]

The present disclosure is applicable to a battery management system or the like in which wireless communication is performed within the system.

### [Reference Signs List]

1 BMS
10 battery pack
11 battery cell
20 junction box
100 monitoring circuit
101, 103 CMU (Cell Monitoring Unit)
111, 113, 211, 212, 315, 317 wireless communication circuit
112, 114 voltage monitoring circuit
121, 141, 221, 331 voltage conversion circuit
122, 142, 222, 332 timer circuit
123, 145, 223, 323, 333 communications interface
124, 224, 334 clock generation circuit
125, 146, 225, 324, 335 phase-locked loop
126, 226, 337 modulation circuit
127, 227, 338 transmission circuit
128, 228, 339 demodulation circuit
129, 229, 340 reception circuit
130 non-volatile memory
131, 231, 341 communication error determination circuit
132, 232, 342 wake-up circuit
133, 343 LED
143 multiplexer
144, 322 AD converter
147, 241, 243, 325, 336 encryption circuit
148 switch
149, 150, 151, 152 comparator
200 management circuit
202 BMU
213 MCU
242, 244 identification circuit
245 table
302, 303 CMU (Current Monitoring Unit)
314, 316 current measurement circuit
321 amplification circuit
400 motor
401 relay
403, 404 shunt resistor
405 power line
ANT 1, ANT 2, ANT 3, ANT 4, ANT 5, ANT 6 communication antenna

## Claims

1. A battery management system for managing a battery assembly, the battery management system comprising:
a management circuit that manages the battery assembly; and
a plurality of monitoring circuits that monitor the battery assembly, wherein
a first monitoring circuit among the plurality of monitoring circuits includes a first wireless communication circuit and a first communication antenna for communicating with the management circuit,
a second monitoring circuit among the plurality of monitoring circuits includes a second wireless communication circuit and a second communication antenna for communicating with the management circuit, and
a modulation scheme of wireless communication by the first wireless communication circuit is different from a modulation scheme of wireless communication by the second wireless communication circuit.

2. The battery management system according to claim 1, wherein
the modulation scheme of the wireless communication by the first wireless communication circuit is one of spread spectrum, orthogonal frequency division multiplexing (OFDM), or ultra wide band (UWB), and
the modulation scheme of the wireless communication by the second wireless communication circuit is one of spread spectrum, OFDM, or UWB that is different from the modulation scheme of the wireless communication by the first wireless communication circuit.

3. A battery management system for managing a battery assembly, the battery management system comprising:
a management circuit that manages the battery assembly; and
a plurality of monitoring circuits that monitor the battery assembly, wherein
a first monitoring circuit among the plurality of monitoring circuits includes a first wireless communication circuit and a first communication antenna for communicating with the management circuit,
a second monitoring circuit among the plurality of monitoring circuits includes a second wireless communication circuit and a second communication antenna for communicating with the management circuit, and
a wireless communication channel used for wireless communication by the first wireless communication circuit is different from a wireless communication channel used for wireless communication by the second wireless communication circuit.

4. The battery management system according to claim 3, wherein
the wireless communication channel used for the wireless communication by the first wireless communication circuit is assigned according to identification information assigned to the first monitoring circuit, and
the wireless communication channel used for the wireless communication by the second wireless communication circuit is assigned according to identification information assigned to the second monitoring circuit.

5. The battery management system according to any one of claims 1 to 4, wherein
a transmission wireless communication channel used for the wireless communication by the first wireless communication circuit is different from a reception wireless communication channel used for the wireless communication by the first wireless communication circuit.

6. The battery management system according to any one of claims 1 to 5, wherein
the plurality of monitoring circuits include a cell monitoring circuit that monitors one or more battery cells included in the battery assembly or a current monitoring circuit that measures current flowing in the battery assembly.
